# EUROPEAN PATENT APPLICATION

(11) **EP 1 614 767 A1**
(43) Date of publication of application: **11.01.2006**
(21) Application number: 05014883.2
(22) Date of filing: 08.07.2005
(51) Int. Cl.: C23C 14/34

(54) **Target tiles in a staggered array**

(30) Priority: 09.07.2004 US 888383; 21.06.2005 US 158270
(71) Applicant: APPLIED MATERIALS, INC., Santa Clara, California 95054 (US)
(72) Inventor: Tepman, Avi, Cupertino, CA 95014 (US)
(74) Representative: Zimmermann, Gerd Heinrich

(57) **Abstract**

A sputtering target (80), particularly for sputter depositing a target material onto large rectangular panels, in which a plurality of target tiles (32) are bonded to a backing plate (34) in a two-dimensional non-rectangular array such that the tiles meet at interstices (84) of no more than three tiles, thus locking the tiles against excessive misalignment during bonding and repeated thermal cycling. The rectangular tiles may be arranged in staggered rows or in a herringbone or zig-zag pattern. Hexagonal and triangular tiles (132; 144) also provide many of the advantages of the invention. Sector-shaped tiles (154) may be arranged in a circular target (150) with a staggered offset (156) at the center.

## Description

This application is a continuation in part of Serial No. 10/888,383, filed July 9, 2004, incorporated herein by reference.

The invention relates generally to sputtering of materials. In particular, the invention relates to a target containing multiple tiles of target material.

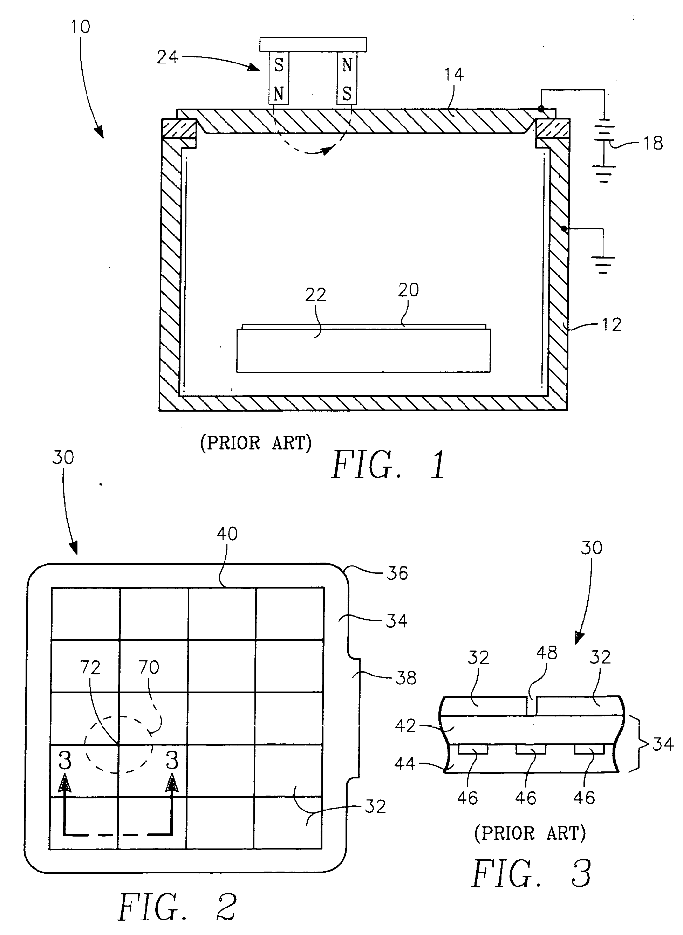

Sputtering, alternatively called physical vapor deposition (PVD), is widely used in the commercial fraction of semiconductor integrated circuits for depositing layers of metals and related materials. A typical DC magnetron plasma reactor 10 illustrated in cross section in FIG. 1 includes an electrically grounded vacuum chamber 12 to which a target 14 is vacuum sealed through an electrical isolator 16. A DC power supply 18 negatively biases the target 14 with respect to the chamber 12 or a grounded sputter shield within the chamber 12 to excite an argon sputter working gas into a plasma. However, it is noted that RF sputtering is also known. The positively charged argon ions are attracted to the biased target 14 and sputter material from the target 14 onto a substrate 20 supported on a pedestal in opposition to the target 14. A magnetron 24 positioned in back of the target projects a magnetic field parallel to the front face of the target 14 to trap electrons, thereby increasing the density of the plasma and increasing the sputtering rate. In modem sputter reactors, the magnetron may be small and be scanned about the back of the target 14. Even a large magnetron may be scanned in order to improve the uniformity of erosion and deposition.

Although aluminum, titanium, and copper targets may be formed as a single integral member, targets for sputtering other materials such as molybdenum, chromium, and indium tin oxide (ITO) are more typically formed of a sputtering layer of the material to be sputtered coated onto or bonded to a target backing plate of less expensive and more readily machinable material.

Sputter reactors were largely developed for sputtering onto substantially circular silicon wafers. Over the years, the size of silicon wafers has increased from 50mm diameters to 300mm. Sputtering targets or even their layers of sputtering material need to be somewhat larger to provide more uniform deposition across the wafer. Typically, wafer sputter targets are formed of a single circular member for some materials such as aluminum and copper or a single continuous sputter layer formed on a backing plate for more difficult materials.

In the early 1990's, sputter reactors were developed for thin film transistor (TFT) circuits formed on glass panels to be used for large displays, such as liquid crystal displays (LCDs) for use as computer monitors or television screens. Demaray et al. describe such a reactor in U.S. Patent 5,565,071, incorporated herein by reference. The technology was later applied to other types of displays, such as plasma displays and organic semiconductors including organic light emitting diodes (OLEDs), and on other panel compositions, such as plastic and polymer. Some of the early reactors were designed for panels having a size of about 400mm×600mm. It was often considered infeasible to form such large targets with a single continuous sputter layer. Instead, multiple tiles of sputtering materials are separately bonded to a single target backing plate. In the original sizes of flat panel targets, the tiles could be made big enough to extend across the short direction of the target so that the tiles form a one-dimensional array on the backing plate.

Because of the increasing sizes of flat panel displays being produced and the economy of scale realized when multiple displays are fabricated on a single glass panel and thereafter diced, the size of the panels has been continually increasing. Flat panel fabrication equipment is commercially available for sputtering onto panels having a minimum size of 1.8m and equipment is being contemplated for panels having sizes of 2m×2m and even larger. For such large targets, a two-dimensional tile arrangement illustrated in plan view in FIG. 2 may become necessary. Rectangular target tiles 32 are arranged in a rectangular array and bonded to a target backing plate 32. Tepman in U.S. Patent Application 10/863,152, filed June 7, 2004 and incorporated herein by reference a two-dimensional magnetron scan of such a large target.

As shown in the plan view of FIG. 2, a substantially rectangular target 30 includes rectangular target tiles 32 arranged in a rectangular array and bonded to a target backing plate 34. The tile size depends on a number of factors including ease of fabricating the tiles and they may number 4x5, but the tiles 32 may be of substantial size, for example 75mm×90mm, such that a 3×3 array is required for a larger panel. The number of tiles in the tile array may be even greater if the target material is difficult to work with, such as chromium or molybdenum. The illustrated target backing plate 34 is generally rectangularly shaped to conform to the shape and size of the panel being sputter coated but its corners 36 may be rounded or angled to conform to the chamber body supporting it and it includes an extension 38 from the chamber body containing an electrical terminal for powering the target and pipe couplings for the cooling fluid used to cool the target 30. As illustrated in cross section in FIG. 3, the target backing plate 34 for flat panel sputtering is typically formed from two metal plates 42, 44, for example, of titanium welded or otherwise bonded together. This backing plate 34 is more complex than the usual backing plate for wafer processing since, for the very large panel sizes, it is desired to provide a backside vacuum chamber rather than the usual cooling bath so as to minimize the differential pressure across the very large target 30. One of the plates 42, 44 is formed with linear cooling channels 46 through which the cooling fluid circulates. Other types of backing plates 34 and cooling channels 46 are possible.

The tiles 32 are bonded to the backing plate 34 on its chamber side with a gap 48 possibly formed between the tiles 32. Typically, the tiles 32 have a rectangular shape with perpendicular corners with the possible exception of beveled edges at the periphery of the tile array. The gap 48 is intended to satisfy fabricational variations and may be between 0 and 0.5mm. Neighboring tiles 32 may directly abut but should not force each other. On the other hand, the width of the gap 48 should be no more than the plasma dark space, which generally corresponds to the plasma sheath thickness and is generally somewhat greater than about 0.5mm for the usual pressures of argon working gas. Plasmas cannot form in spaces having minimum distances of less than the plasma dark space. As a result, the underlying titanium backing plate 34 is not sputtered while the tiles 32 are being sputtered.

Returning to FIG. 2, the tiles 32 are arranged within a rectangular outline 40 conforming approximately to the area of the target 30 desired to be sputtered or somewhat greater. The magnetron 24 of FIG. 1 is scanned with this outline 40. Shields or other means are used to prevent the untiled surface of the backing plate 34 from being exposed to high-density plasma and be thereby sputtered. Clearly, sputtering an aluminum backing plate 34 supporting molybdenum or other tiles is not desired. Even if the backing plate 34 is composed of the same material as the target tiles 32, sputtering of the backing plate 34 is not desired. The backing plate 34 is a complex structure and it is desired to refurbish it after one set of tiles 32 have been exhausted and to use it for a fresh set of tiles 32. Any sputtering of the backing plate 34 should be avoided.

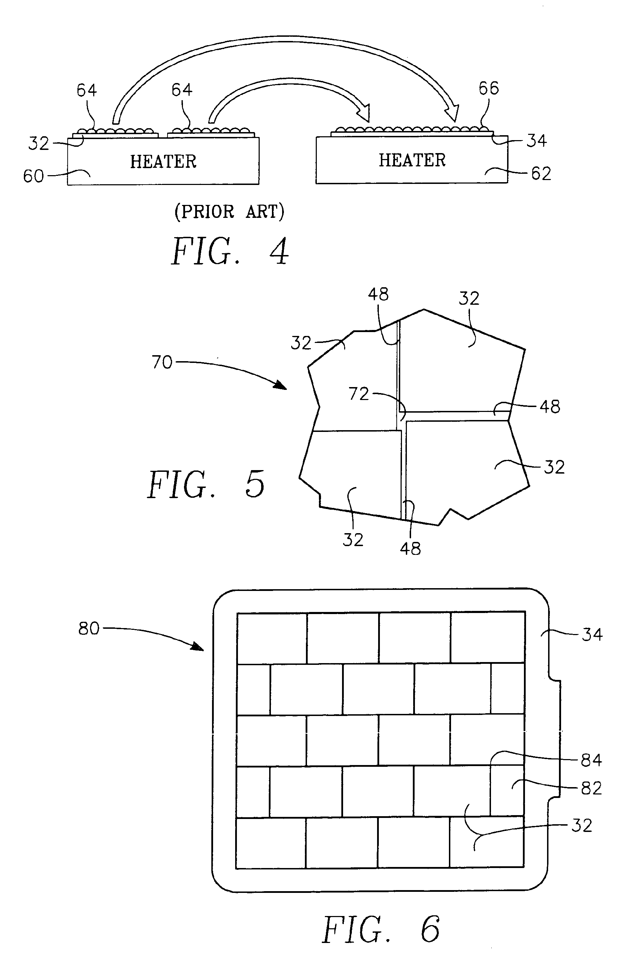

The rectangular tile arrangement of FIG. 2 presents difficulties with increases in the panel size. There are several processes available for bonding target tiles to backing plates. One popular process illustrated in FIG. 4 includes an apparatus comprising two heating tables 60, 62. The tiles 32 are placed on one table 60 with their sputtering face oriented downwards. Each tile 32 is painted on its backside with a coating 64 of indium. The heating table 60 heats the coated tiles 32 to about 200°C, far above indium's melting point of 156°C so that indium wets to the tiles 32 and forms a uniform molten layer. Similarly, the backing plate 34 is placed on the other heating table 62 and is painted with an indium coating 66 and is heated to about 200°C. With all indium coatings 64, 66 in their molten state, the tiles 32 are removed from the first table 60, inverted, and placed on top of the backing plate 34 with the melted indium coatings 64, 66 facing each other and the sputtering faces oriented upwards. Upon cooling, the indium solidifies and bonds the tiles 32 to the backing plate 34.

The transfer operation must be performed quickly enough that the indium coating 64 on the tiles 32 does not solidify during transfer. For smaller targets, the transferring could be done manually. However, with the target and tiles becoming increasingly larger, a transfer fixture grasps the edges of the tiles, and a crane lifts the fixture and moves it to the second table.

Such large mechanical structures are not easily manipulated to provide the desired degree of alignment, specifically, the bonded tiles being separated by no more than 0.5mm. Instead, as illustrated for a corner area 40 between four tiles 32 in the plan view of FIG. 5, the four tiles 32 arranged in a rectangular array tend to slide along each other and be misaligned with different sizes for the inter-tile gaps 48. More importantly, an interstice 72 between the corners of the four tiles may become much larger than intended. By an interstice is meant a point or space at the interfaces between three or more tiles so that the term does not include the line between two tiles. Even a well defined interstice 72 presents the greatest gap between tiles 32. As a result, the widest point of the interstice 72 for misaligned tiles 32 may become larger than the plasma dark space, e.g., 1mm, so that the plasma may propagate towards the backing plate 34. If the gap is only slight larger than the plasma dark space, the plasma state in the gap may be unsteady and result in intermittent arcing. Even if the arcing is confined to tile material, the arc is likely to ablate particles of the target material rather than atoms and create contaminant particles. If the plasma reaches the backing plate, it will be sputtered. Plate sputtering will introduce material contamination if the tiles and backing plate are of different materials. Furthermore, plate sputtering will make it difficult to reuse the backing plate for a refurbished target. Even if the plasma does not immediately reach the backing plate, an oversized interstice 72 allows the plasma to sputter the sides of the tiles 32 facing the interstice 72. The side sputtering will further enlarge the interstice 72 and worsen the situation of plate sputtering.

A similar problem arises from the differential thermal expansion between the materials of the target tiles and the backing plate. When the bonded assembly is cooled to room temperature, the differential thermal expansion is likely to cause the assembly to bow. Because of the softness of solid indium, the bow can be pressed out of the bonded assembly. However, the pressing is a generally uncontrolled process and the tiles may slide relative to each other during the pressing to create the undesired tile arrangement of FIG. 5.

Techniques have been developed to bond tiles to backing plates with a conductive elastomer that can be applied at a much lower temperature. Such bonding services are available from Thermal Conductive Bonding, Inc. of San Jose, California. Nonetheless, elastomeric bonding does not completely eliminate the misalignment problem with larger array of target tiles.

The present invention intends to overcome at least some of the above problems. The object is solved by a sputtering target according to claim 1, a plasma sputtering reactor according to claim 19, and a method of sputtering according to claim 22. Further advantages, features, aspects and details of the invention are evident from the dependent claims, the description and the drawings.

A target, particularly useful as a rectangular target, includes rectangular target tiles which are bonded to a target backing plate in a non-rectangular two-dimension array.

The rectangular tiles may be arranged in staggered rows such that only three tiles meet at an interstice and only two of those tiles have acute corners adjacent to the interstice. In one embodiment of the row arrangement, one row may include only plural whole tiles while a neighboring row has one less whole tile and two half tiles on the ends. In another embodiment of the row arrangement, all rows include the same number of whole tiles and one partial tile with the partial tiles being disposed on opposed ends of neighboring rows. In another embodiment of the row arrangement the offset creating the staggering is less than 10% but more than 0.5% of the length of the tiles along the row. In another embodiment, the plurality of target tiles may be 6.

The rectangular tiles may alternatively be arranged in a herringbone or zig-zag pattern of whole rectangular tiles having a 1:2 or even 1:*N* size ratio and square tiles disposed on the periphery of the rectangular outline.

Alternatively, the tiles may be hexagonally shaped and arranged in a close-packed structure.

Yet further alternatively, the tiles may be triangularly shaped, preferably having isosceles shapes within the interior of the rectangular outline.

The invention may be applied to circular targets having multiple tiles, particularly those having sector shaped tiles. Advantageously, the sectors may meet at a staggered junction near the center. Preferably, the plurality of target tiles can be four, and an offset between tiles at said staggered junction can be between 0.5 and 10% of a radial length of said sector-shaped tiles.

In another aspect of the invention, the outside corners of the target tiles are curved with a radius of between 6.5 to 12.5cm in correspondence to the curvature of the plasma track created by the magnetron near those corners. The curved corners can be applied to a single-tile target and to one- and two-dimensional arrays of tiles.

In another aspect of the invention, the tiles are arranged in staggered rows, each of said rows having a width of a first length, all of said tiles having first sides extending perpendicularly to said rows of lengths substantially equal to said first length. In another aspect, the tiles excluding those at a periphery of said array have second sides extending perpendicularly to said rows of lengths substantially equal to a second length.

In still another aspect of the invention, a sputtering target, particularly for sputter depositing a target material onto large rectangular panels, is provided, in which a plurality of target tiles are bonded to a backing plate in a two-dimensional non-rectangular array such that the tiles meet at interstices of no more than three tiles, thus locking the tiles against excessive misalignment during bonding and repeated thermal cycling. The rectangular tiles may be arranged in staggered rows or in a herringbone or zig-zag pattern. Hexagonal and triangular tiles also provide many of the advantages of the invention. Sector-shaped tiles may be arranged in a circular target with a staggered offset at the center.

The invention is also directed to apparatuses for carrying out the disclosed methods and including apparatus parts for performing each described method steps. These method steps may be performed by way of hardware components, a computer programmed by appropriate software, by any combination of the two or in any other manner.

The invention will be better understood by reference to the following description of embodiments of the invention taken in conjunction with the accompanying drawings, wherein:
FIG. 1 is a schematic cross-sectional view of a conventional plasma sputter reactor.
FIG. 2 is a plan view of rectangular target formed from a two-dimensional array of target tiles.
FIG. 3 is a cross-sectional view of a configuration of target tiles bonded to a conventional target backing plate including cooling channels.
FIG. 4 is a schematic view illustrating a conventional method of bonding target tiles to a backing plate.
FIG. 5 is a plan view illustrating a problem with the conventional rectangular arrangement of target tiles.
FIG. 6 is a plan view of a first embodiment of the invention including rectangular target tiles arranged in staggered rows.
FIG. 7 is a plan view of a second embodiment including rectangular tiles arranged in staggered rows with partial end tiles of the same size arranged on opposing ends of neighboring rows.
FIG. 8 is a plan view of a third embodiment including rectangular tiles of nearly but not exactly the same dimensions arranged in staggered rows with a reduced offset between the rows.
FIG. 9 is a plan view of a third embodiment including rectangular tiles arranged in a herringbone or zig-zag pattern.
FIG. 10 is a plan view of a fourth embodiment including hexagonal tiles.
FIG. 11 is a plan view of a fifth embodiment including triangular tiles.
FIG. 12 is a plan view of an embodiment of the invention applied to a circular target.

Targets made according to the invention avoid many of the problems of conventional targets composed of tiles arranged in a rectangular array. Instead, as illustrated in the plan view of FIG. 6, a target 80 of one embodiment of the invention includes rectangular tiles 32 each of substantially the same composition at least on its sputtering face and arranged in staggered rows and bonded to the target backing plate 34. In this embodiment, the tiles 32 of one row are offset in the row direction from the tiles 32 of the neighboring rows. In some of the rows, end tiles 82 have a length in the row direction that is only a fraction of the corresponding length of full tiles 32. In this embodiment, it is preferred that the length of the end tiles 82 be one-half the full length less the desired size of the gap between tiles so that only two sizes of tiles 32, 82 are needed. While the tiles 32, 82 can still slide in the row direction during their transfer to and bonding with the backing plate 34, movement in the perpendicular direction is quite limited. As a result, interstices 84 at the corners between tiles 32, 82 are much less likely to grow to abnormally large sizes. Furthermore, each interstice 84 forms between three tiles 32, 82 and only two of the tiles 32, 82 present acute angles to the interstice 84. Accordingly, plasma arcing is less severe than with four tiles presenting four acute angles, as in the prior art target 30 of FIG. 1.

The target 80 contains some rows containing a number N of whole tiles 32 alternating with rows containing *N-1* whole tiles 32 and two half tiles 82. Within a factor that is a ratio of the number of rows and number of columns, the aspect ratio of the whole tiles 32 determines the aspect ratio of the useful target area covered by the tile 32, 82.

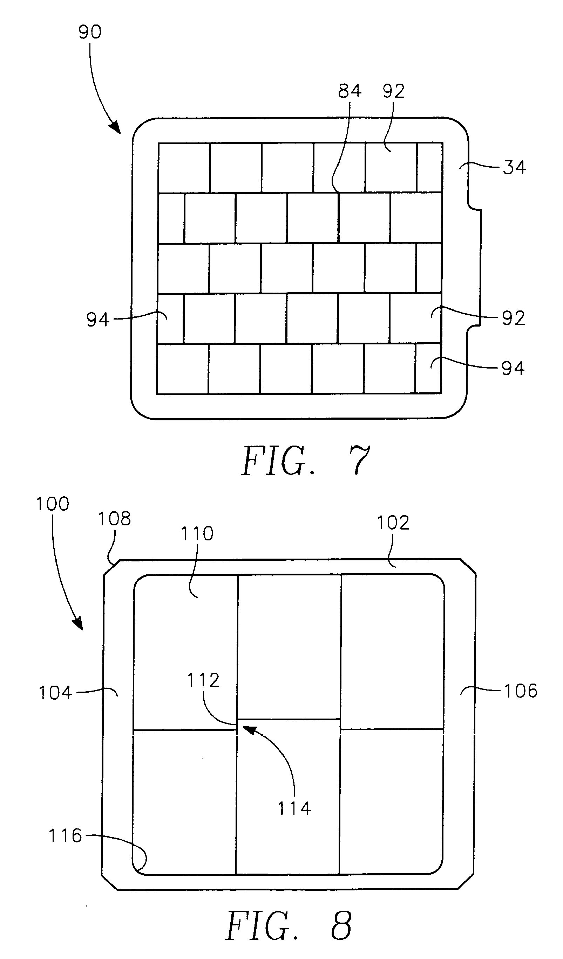

A closely related target 90 illustrated in plan view in FIG. 7 has rectangular tiles 92 arranged in rows all containing N full tiles 92 and one partial rectangular tile 94. The partial tiles 94 are arranged on opposite ends of neighboring rows and may have the same length in the row direction so that only two sizes of tiles are required. The length of the partial tiles 94 in the row direction is not limited to one-half the corresponding length of the full tiles 92. Even if the full tiles 92 are square, the aspect ratio of the useful area of the target can be nearly freely chosen by varying the row dimension of the partial tiles 94.

In both the targets 80, 90, the full tiles 32 are arranged in a parallelogram arrangement of similarly oriented tiles 32.

A target 100 of another related embodiment is illustrated in the bottom plan view of FIG. 8. A backing plate 102 includes on opposed side two extensions 104, 106 protruding beyond the outline of the chamber and accommodating exterior plumbing connections allowing cooling liquid to flow directly from one side to the other and angled corners 108. Six generally rectangular tiles 110 are bonded to the backing plate 102 preferably with either indium or a polymeric adhesive in a predetermined staggered two-dimensional arrangement with gaps of about 0.5mm between the tiles 110. Independent of the specific embodiment other numbers, e.g. 8 of generally rectangular tiles 110 may be bonded. The arrangement, however, reduces the amount of an offset 112 between neighboring columns at an offset junction 114 of four tiles 110 at to less than 10% of the length of the tiles along the direction of the offset 112. The offset should be greater than the gap, for example, by a factor of at least 2 to 4, and preferably greater than 0.5% of the length of the associated sides of the tiles 110, although offsets down to 0.2% may be used. The reduced offset 112 is advantageous in view of the typical method of forming the tiles 110. Tile blanks larger than the desired tiles are formed by high isothermal pressing (HIP) in a mold, which is a form of sintering. The edges of the tile blanks, which contain the most impurities, are then machined away to form the desired tile shape. Tiles 110 formed with minimal effective offset 112 to eliminate four-point junctions can be formed from one size of mold and tile blank with minimal wastage of target material.

The illustrated tiles 110 also have rounded outside corners 116, that is, the corners of the array of tiles 110. The radius of curvature, which may be between 6.5 to 12.5 cm is chosen to follow the curvature of the corners of the magnetron. The magnetrons described by Tepman in the afore cited patent document include a convolute plasma track formed between an inner pole of one magnetic polarity and a surrounding outer pole of the opposed magnetic polarity with a substantially constant gap there between, which defines the plasma track. The pole pieces include linear sections joined by curved 90° and 180° sections. The outside corners 116 of the tiles 110 preferably conform to the curvature of the plasma track near those corners 116.

A similarly curved outside corners are advantageously applied to a one-dimensional rectangular array of target tiles or to a single rectangular target tile, which are the preferred arrangements if the tiles can be made large enough.

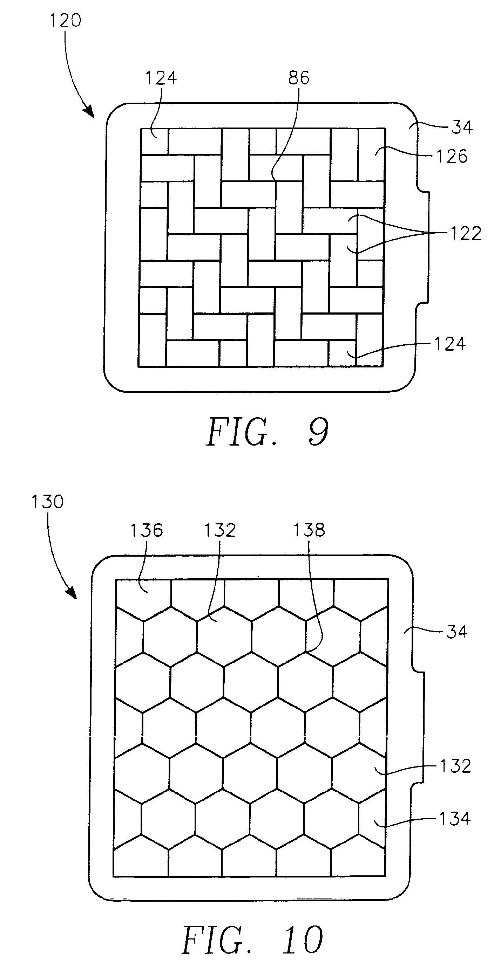

A target 120 of a third embodiment of the invention is illustrated in FIG. 9 has rectangular tiles arranged in a herringbone arrangement, alternatively called a zig-zag arrangement. Viewed in the orientation of FIG. 9, the herringbone pattern includes tiles 122 having an 1:2 aspect ratio, taking into account any desired gap between the tiles 122. In the herringbone pattern, the tiles 122 are arranged in both the vertical and horizontal directions with paths passing through the short dimension of a first tile on a first end, through the long dimension of a second tile, and then through the short dimension of a third tile on a second end opposite the first end of the second tile. Thereafter, the pattern repeats. Viewed along the direction of the diagonal passing from lower left to upper right, there are parallel chevron patterns along the diagonal of pairs of orthogonally arranged tiles 122. The edges around the rectangular pattern require several half tiles 124. Note that a whole tile 126 at the upper right corner replaces two half tiles of the precise herringbone pattern.

The herringbone pattern provides many interlocking corners and thus allows little slippage to accumulate. This rigidity is accomplished with only two sizes of tiles. However, there is very little flexibility in the aspect ratio of the tiles in the simple illustrated herringbone pattern so that the overall aspect ratio of the useful area of the target is constrained to ratios of small integers. The target aspect ratio can be more freely chosen if rectangularly shaped target tiles of nearly arbitrary aspect ratio are lined up on one of the edges of the herringbone pattern. (A similar edge row of differently sized tiles may be used with the other rectangular arrangements to more easily attain an arbitrary aspect ratio.) The herringbone pattern can be characterized as pairs of perpendicularly oriented 1:2 tiles arranged in an parallelogram pattern. However, there are more complex herringbone patterns in which the tiles have aspect ratios of 1:*N*, where *N* is an integer greater than 1.

In all the rectangular embodiments described above with reference to FIGS. 6 through 9, a tile in the interior of the two-dimensional array away from the periphery abuts along a line six other tiles, whether they be full or partial tiles in contrast to the four tiles abutted in the rectangular arrangement of FIG. 2.

All the previously described patterns involve generally rectangular tiles. In contrast, a target 130 illustrated in plan view in FIG. 10, includes regular hexagonal tiles 132 arranged in a hexagonal close packed structure, alternatively characterized as a rhombohedral pattern with one pair of sides aligned with the rectangular outline. It is not conventional to fabricate tiles in non-rectangular shapes. However, targets of many high-temperature metals are formed by sintering powders in a mold, as previously described. The mold can be shaped in the required non-rectangular shape, in this embodiment a hexagonal shape, though of somewhat larger size to allow edge removal and straightening. Fitting the hexagonal tiles 132 into a rectangular shape requires extra edge pieces. However, in the design of FIG. 10, the edge pieces can be restricted to tiles of two shapes, trapezoidal tiles 134 along set of opposed edges, which are half hexagons, and pentagonal tiles 136 along the other set of opposed edges. Although the illustrated hexagons are regular, they may be stretched or shrunk along one opposed pair of sides with all interior corners maintained at 60°. Even with regular hexagons having a fixed aspect ratio, the length of the parallel sides of the pentagonal tiles 136 may be varied to provide more freedom in the overall target aspect ratio. The limitation to three sizes of tiles 132, 134, 136 is obtained when there are an odd number of rows in the illustrated orientation of an odd number of abutting hexagon tiles 132, one of which may be split into two trapezoidal tiles 134 for the edges. The hexagonal arrangement produces interstices 138 abutting three tiles 132 (including edge tiles 134, 136 as appropriate). Each of the abutting tiles abuts at corners having an exterior obtuse angle of 120°. Similarly to the rectangular patterns of the invention, each hexagonal tile 132 in the interior of the arrangement abuts along a line six other tiles, whether they be full or partial tiles.

The rectangular and hexagonal tiles described above have interior angles of 90° and 60° respectively. It is possible to modify these shapes to more oblique shapes. As long as the opposed sides of the tiles are parallel, they can be close packed. However, such oblique shapes require additional edge pieces.

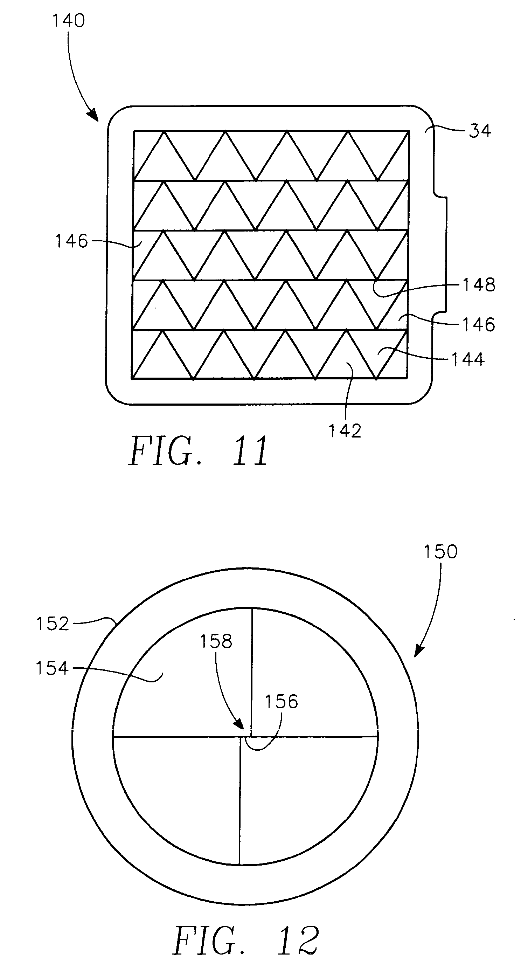

Another target 140 illustrated in plan view in FIG. 11 includes triangular tiles. In the illustrated embodiment, each row includes alternating triangular tiles 142, 144 of the same shape of an isosceles triangle but with inverted orientations with respect to the perpendicular of the horizontally illustrated row direction. Two right triangular tiles 146 are disposed at the end of the rows to provide the desired overall rectangular shape. If there are matched pairs of tiles 142, 144 in each row, that is, N of each, then the right triangular end tiles 148 have the same shape even if their tops and bottoms need to be differentiated. As a result, only two sizes of tiles 142, 144, and 146 are required. The vertically oriented vertex of one isosceles tile 144, 146 abuts the base of another similar oriented isosceles tile 144, 146 so that interior interstices 148 are bordered by three acute apexes and one flat side of four respective tiles 144, 146. If the isosceles triangles of the tiles 144, 146 are equilateral triangles, the minimum apex angle is increased and the perimeter-to-area ratio decreased. However, an equilateral design provides little flexibility in overall aspect ratio of the target while a more general isosceles design allows different base-to-side ratios in the triangles. In the illustrated triangular arrangement, each tile 142 or 144 at the interior of the pattern abuts along a line four other triangular tiles, whether they be full or partial. It may be desirable to line one edge of the triangular array, whether isosceles or equilateral, with rectangular tiles of arbitrary aspect ratio to thereby allow an arbitrary target aspect ratio.

The illustrated triangular arrangement can be characterized as a rectangular arrangement of non-rectangular elements although non-rectangular arrangements are possible. In any case, all the embodiments described above include a two-dimensional array of tiles arranged and bonded to the backing plate such that the edges of the tiles do not conform to a rectangular two-dimensional grid, as do the tiles of the arrangement of FIG. 2.

Other triangular shapes and staggering patterns are possible, but the isosceles design of FIG. 11 provides a large minimum apex angle and a small number of extra edge pieces.

The invention is most useful for large rectangular targets having minimum dimensions of greater than 1.8m. However, the invention is applicable to smaller targets for which tiling is still desired. Especially for smaller targets, the target backing plate may be simpler than the one illustrated and not include the cooling channels. The invention may also be applied to circular targets for wafer sputter, for example, as illustrated in FIG. 12, a wafer sputtering target 150 includes a substantially circular backing plate 152 on which are bonded four sector tiles 154 with predetermined gaps between them. An offset 156 at a staggered junction 158 is relatively small, similarly to the rectangular array of FIG. 8, that is between 0.5 and 10% of the radial length of the sector tiles 154. The sector tiles 154 have rounded outer edges, two straight radial sides meeting at apexes at the staggered junction 158, which is near but is not congruent with the center of the backing plate 152. Each of the sector tiles 154 may have a shape which is close to but not exactly a 90° sector.

The invention is useful not only for refractory metal targets such as molybdenum, chromium, and tungsten as well as silicon, targets of which are difficult to fabricate in large sizes. Similarly, the invention is also useful for targets of more complex composition, such as indium tin oxide (ITO), which is typically sputtered from a target of a mixture of indium oxide and tin oxide in the presence of an oxygen ambient. Also, the perovskite materials used for high-k, ferro electric, piezoelectric layers may be sputtered from a target containing a sintered mixture of metals, such as lead, zirconium, and titanium, in the presence of oxygen. Such perovskite-precursor targets may need to be formed of smaller target tiles.

Nonetheless, the invention is also useful for more common metals such as aluminum, copper, and titanium, particularly when a target backing plate is used, which is intended to be refurbished. That is, the invention is not limited to the composition of the target. The invention may further be applied to targets used in RF sputtering, such as insulating targets, as may be used for sputtering metal oxides, such as the previously mentioned perovksites. A magnetron is not essential for the invention. Furthermore, the invention can be applied to round targets although a large variety of edge pieces are required.

Although the invention has been described on the basis of planar bodies having straight sides, it is understood that the edges may have cross-sections of more complexity, such as steps, as long as the overall shape is describable as rectangular, etc. Similarly, the corners of the shape may be somewhat rounded, either intentionally or unintentionally.

The invention thus provides less tile misalignment and improved sputtering performance with only a small increase in the complexity of the tiled target and its fabrication.

## Claims

1. A sputtering target (80; 90; 100), comprising a plurality of target tiles (32; 92; 110) comprising a common sputtering composition and respectively shaped to be arranged in a non-rectangular two-dimensional array.

2. The target of claim 1, wherein the plurality of target tiles are to be arranged with predetermined gaps between the target tiles.

3. The target of any of claims 1 or 2, wherein said tiles have respective rectangular shapes and said two-dimensional array is non-rectangular.

4. The target of claim 3, wherein outside corners (116) of said tiles in said array are rounded with curvatures of between 6.5 and 12.5cm.

5. The target of any of claims 1 through 4, wherein said tiles are arranged in staggered rows.

6. The target of claim 5, wherein said staggered rows are arranged with an offset of between 0.5 and 10% of a length of said tiles along said rows.

7. The target of claim 3, wherein said tiles are arranged in a herringbone pattern.

8. The target of any of claims 1 through 4, wherein said array has a rectangular shape with minimum dimension of at least 1.8m.

9. The target of any of claims 1 through 4, wherein said tiles are arrangeable inside of a generally rectangular outline (40).

10. The target of claim 9, wherein said rectangular outline has rounded corners (116) with curvatures of between 6.5 and 12.5cm.

11. The target of any of claims 1 through 4, further comprising a target backing plate (34; 102; 152) to which the target tiles are bonded.

12. The target of claim 11, wherein said tiles are arranged in staggered rows.

13. The target of claim 12, wherein said staggered rows are arranged with an offset of between 0.5 and 10% of a length of said tiles along said rows.

14. The target of claim 11, wherein said array has a rectangular shape with minimum dimension of at least 1.8m.

15. The sputtering target of any of claims 1 through 4, wherein edges of said tiles do not conform to any rectangular grid.

16. The target of claim 15, wherein said tiles are arranged inside of a generally rectangular outline.

17. The target of claim any of claims 1 through 4, wherein said tiles are rectangular and said two-dimensional array is non-rectangular.

18. The target of any of claims 1 through 4, wherein said tiles are arranged such that neighboring three tiles meet an interstice between right corners of two of said three tiles and a straight edge of a third of said three tiles.

19. A plasma sputtering reactor comprising:
a vacuum chamber (12);
a support (22) for supporting a rectangular substrate (20) to be sputter coated;
a target backing plate (34) vacuum sealed to said chamber in opposition to said support; and
a plurality of rectangular sputtering tiles comprising a material to be sputtered onto said substrate and fixed to said backing plate in a non-rectangular two-dimensional array.

20. The reactor of claim 19, wherein said rectangular tiles are arranged in staggered rows.

21. The reactor of claim 19, wherein said rectangular tiles are arranged in a herringbone pattern.

22. A method of sputtering, comprising the steps of:
affixing to a sputtering chamber a target backing plate (34) to which are affixed a plurality of tiles (32;92;110) comprising a common sputtering material and arranged in a two-dimensional non-rectangular array.
exciting a sputter working gas within said chamber into a plasma to sputter said tiles and deposit said material onto a substrate (20) disposed in opposition to said target backing plate.

23. The method of claim 22, wherein said substrate is rectangular and said tiles are disposed inside of a rectangular outline.

24. The method of either of claims 22 and 23, wherein said substrate is used for one or more display panels.

25. The method of any of claims 22 through 24, wherein said tiles are rectangular.
